# EUROPEAN PATENT APPLICATION

(11) **EP 3 539 671 A1**
(43) Date of publication of application: **18.09.2019**
(21) Application number: 18161712.7
(22) Date of filing: 14.03.2018
(51) Int. Cl.: B03C 3/00

(54) **CHARGING OF AN ELECTRICALLY CONDUCTIVE OBJECT**

(71) Applicant: Nokia Technologies Oy, 02610 Espoo (FI)
(72) Inventor: JEFFERS, Nicholas, Wicklow, A63YH63 (IE)
(74) Representative: Nokia EPO representatives

(57) **Abstract**

An apparatus, system and method is disclosed in relation to charging an electrically conductive object, for example a heat sink associated with an electrical component. The apparatus may comprise a means for sensing a variable property associated with an electrical component. The apparatus may comprise means for applying an electrical signal to an electrically conductive object in proximity of the electrical component so as to charge said object with either a positive or negative charge in the event that the sensing means senses that the variable property is outside of a predetermined range.

## Description

### Field

Example embodiments relate to charging of an electrically conductive object, for example a heat sink in proximity of an electrical component.

### Background

A heat sink is a heat exchanger that transfers the heat generated by an electrical or mechanical device to a fluid medium such as air. In the context of electrical components, it is important that certain components such as processors or power supplies do not overheat as they may otherwise fail or potentially cause damage to other components or the overall system. A further cooling mechanism such as a fan may be positioned adjacent the heat sink in order to carry the transferred heat to an outside environment.

The operation of the heat sink and or an associated cooling mechanism may be compromised by particles such as dust, which tend to adhere to the surface of the heat sink due to, for example, electrostatic charge.

### Summary

An example embodiment provides an apparatus comprising: means for sensing a variable property associated with an electrical component; means for applying an electrical signal to an electrically conductive object in proximity of the electrical component so as to charge said object with either a positive or negative charge in the event that the sensing means senses that the variable property is outside of a predetermined range.

The apparatus may further comprise means to selectively apply the electrical signal to the electrically conductive object so as to charge it with the opposite charge polarity in the event that the sensing means senses that the variable property has not returned towards, or is not within, the allowable range.

The apparatus may further comprise means to connect the electrically conductive object to ground or earth in the event that the sensing means senses that the variable property is in the allowable range.

The means for applying the electrical signal may be configured to apply pulsed signals.

The sensed variable property may be the temperature associated with the electrical component.

The sensing means may a temperature sensor proximate to, or in contact with, the electrically conductive object.

The sensed variable property may be indicative of performance of the electrical component.

The sensing means may be configured to sense a plurality of variable properties associated with the electrical component and wherein the means to apply the electrical signal charges said object only if the plural variable properties are outside respective different allowable ranges.

Another embodiment provides a system comprising: an electrically conductive heat sink for location proximate to an electrical component; an apparatus according to any preceding claim for charging of the heat sink.

The heat sink may be dimensioned and arranged to substantially enclose the electrical component.

A thermally conductive substance may be provided in a chamber defined between the electrical component and the heat sink to permit transfer of heat from the electrical component to the heat sink through said substance, wherein the sensed variable property is temperature associated with the electrical component or heat sink.

The thermally conductive substance may be a gas or vapour. The thermally conductive substance may be aluminium nitride vapour.

Another example embodiment provides a method comprising: sensing a variable property associated with an electrical component; applying an electrical signal to an electrically conductive object in proximity of the electrical component so as to charge said object with either a positive or negative polarity in the event that the sensing means senses that the variable property is outside of an allowable range.

The method may further comprise selectively applying the electrical signal to the electrically conductive object so as to charge it with the opposite charge polarity in the event that the sensed variable property has not returned towards, or is not within, the allowable range.

The method may further comprise connecting the electrically conductive object to ground or earth in the event that the sensed variable property is in the allowable range.

Applying the electrical signal may use pulsed signals.

The sensed variable property may be the temperature associated with the electrical component.

The sensing may be temperature sensing of the electrically conductive object.

The sensed variable property may be indicative of performance of the electrical component.

Sensing means may be sensing a plurality of variable properties associated with the electrical component and wherein applying the electrical signal charges said object only if the plural variable properties are outside respective different allowable ranges.

Another embodiment provides a system comprising: an electrically conductive heat sink for location proximate to an electrical component; an apparatus according to any preceding claim for charging of the heat sink.

The heat sink may be dimensioned and arranged to substantially enclose the electrical component.

Another example embodiment provides computer-readable instructions which, when executed by at least one processor, cause the at least one processor to perform the method of any preceding method definition.

Another embodiment provides a non-transitory computer-readable medium having stored thereon computer-readable code, which, when executed by at least one processor, causes the at least one processor to perform a method, comprising: sensing a variable property associated with an electrical component; applying an electrical signal to an electrically conductive object in proximity of the electrical component so as to charge said object with either a positive or negative polarity in the event that the sensing means senses that the variable property is outside of an allowable range.

Another aspect provides an apparatus, the apparatus having at least one processor and at least one memory having computer-readable code stored thereon which when executed controls the at least one processor: to sense a variable property associated with an electrical component; to apply an electrical signal to an electrically conductive object in proximity of the electrical component so as to charge said object with either a positive or negative polarity in the event that the sensing means senses that the variable property is outside of an allowable range.

### Brief Description of Drawings

Example embodiments will now be described by way of example only with reference to the accompanying drawings, in which:
FIG. 1 is a schematic diagram of a system for charging a conductive object associated with an electrical component in one example embodiment;
FIG. 2 is a first example charge circuit which may be used in the FIG. 1 system in a first configuration;
FIG. 3 is the first example charge circuit in a second configuration;
FIG. 4 is the first example charge circuit in a third configuration;
FIG. 5 is a second example charge circuit which may be used in the FIG. 1 system in a second configuration;
FIG. 6 is the second example charge circuit in a second configuration;
FIG. 7 is the second example charge circuit in a third configuration;
FIG. 8 shows first and second waveforms respectively showing temperature and charge voltage against time, illustrating the operation of the FIG. 5 - 7 charge circuit configurations;
FIG. 9 is a schematic diagram of functional modules of a control system that may used in charging the conductive object under software control;
FIG. 10 is a flow diagram showing processing operations that may be performed in accordance with one example embodiment; and
FIG. 11 is a flow diagram showing processing operations that may be performed in accordance with another example embodiment;

### Detailed Description of Example Embodiments

Example embodiments to be described relate to systems and methods for applying one or more electrical signals to an electrically conductive object in order to selectively charge said electrically conductive object.

The electrically conductive object can be any type of object. However, the specification will focus on heat sink objects which may be associated with one or more electrical components. The heat sink object may be formed of metallic material, or any other similar material being an electrical conductor. Heat sinks take various forms and shapes, may comprise radiating fins and so on, and embodiments herein are not limited to any particular form or shape.

The term electrical component is also intended to cover electronic components, and may include passive and active components including microprocessors, power supplies and memory, to give some examples.

The heat sink may be positioned proximate, e.g. adjacent, and possibly in contact with the electrical component. The heat sink may be associated with a plurality of electrical components. The heat sink may be shaped and dimensioned so as to provide an enclosure for the one or more electrical components.

Heat sinks tend to be grounded, i.e. at zero volts, when provided in an electrical system, e.g. on a printed circuit board (PCB). This can cause airborne particles such as dust to adhere to the surface of the heat sink because the dust particles carry an electrostatic charge. The dust is not repelled due to the heat sink being grounded. More dust may be attracted to the heat sink due to the electrostatic charge and may build to the extent that the cooling effect of the heat sink is compromised. When particles adhere to heat sink fins, for example, convection is compromised and thermal resistance from the electrical component to the outside environment is increased.

Example embodiments herein relate to an apparatus that senses a variable property associated with the electrical component, selectively applies an electrical signal to a heat sink in proximity of the electrical component, e.g. in the thermal path to the outside environment, in order to charge the heat sink with either a positive or negative polarity in the event that the sensed variable property is outside of an allowable range.

In this manner, feedback is employed in terms of the sensed variable property to selectively charge the heat sink. If the polarity of the charging is the opposite of particles on the heat sink, they will be repelled from the heat sink.

Some example embodiments of the apparatus further comprise means to selectively apply the electrical signal to the heat sink so as to charge it with the opposite polarity in the event that, after a predetermined time period, the sensing means senses that the variable property has not returned to the allowable range.

In this manner, the feedback is monitored for the time period and if the variable property has not returned to the allowable range, then it may be assumed that the charging polarity needs to be reversed. The time period may be a predetermined time period such as 1-5 minutes although it may depend on the thermal mass of the heat sink.

Some example embodiments of the apparatus further comprise means to selectively connect the heat sink to ground or earth (zero volts) in the event that the sensing means senses that the variable property is in the allowable range.

In this manner, if the feedback indicates that the variable property is allowable, there is no need to charge the heat sink and hence it can be, temporarily at least, grounded. This also saves on power needed to cause charging.

Some example embodiments of the apparatus involve applying pulsed signals having either negative or positive polarity to effect the selective charging. This also saves on power needed to cause charging because the heat sink will hold charge when not grounded.

The allowable range may be predetermined, and may be derived based on experiments or tests, such as to identify a range of the variable property values that correspond to efficient and/or correct operation of the component and/or which does not cause adverse or unwanted conditions to arise or increase. The above time period may be determined in a similar manner. The allowable range may be known to component manufacturers, possibly advised in a datasheet of the component.

The sensed variable property may be temperature, or some signal, whether analogue or digital, indicative of the component performance.

For example, a temperature sensor such as an electrical thermometer, thermocouple or similar device for indicating temperature or a change in temperature may be employed. For example, the temperate sensor may be posited proximate or in contact with the electrical component.

In some example embodiments, the temperature sensor can sense the temperature of the electrical component without direct contact with the electrical component. For example, a thermally conductive substance may be located between the electrical component and the heat sink. In this way, the temperature of the heat sink may be indicative of the temperature of the component. For example, the thermally conductive substance may be an electrically insulating but thermally conductive ceramic, such as aluminium nitride. The heat sink may be dimensioned and arranged so as to substantially enclose one or more underlying electrical components and between the heat sink and the electrical component may be provided the electrically insulating and thermally conductive substance to electrically isolate the heat sink from the electrical component.

Example embodiment of the apparatus may use analogue or digital circuitry and may involve the use of microprocessor and/or microcontroller components, or any combination of the above.

More specific example embodiments will now be described.

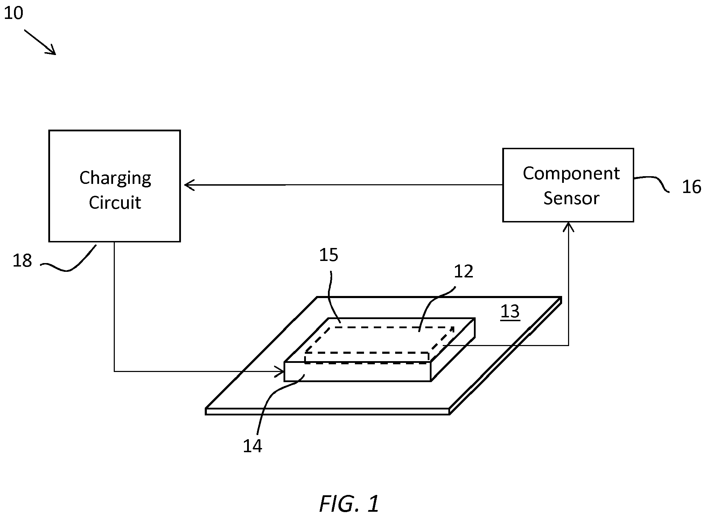

FIG. 1 shows a system 10 comprising an electrical component 12, for example a microprocessor, mounted on a printed circuit board (PCB) 13. The electrical component 12 is enclosed by heat sink 14. For example, the heat sink 14 may be formed of metal material such as aluminium or copper. The heat sink 14 is not permanently grounded such that it can be charged either positively or negatively in accordance with example embodiments to be described below.

The heat sink 14 may be of any suitable shape or form, but in the shown embodiment comprises a container-like object having four perimeter walls and an upper wall defining a hollow interior chamber within which the electrical component 12 is contained. The shape and dimensions of the heat sink 14 may be such as to leave a gap 15 between the interior surface of the chamber and the electrical component 12, for example so that an electrically insulating but thermally conductive layer can be located therein, for example sandwiched between the heat sink and the electrical component. The heat sink 14 may be attached to the printed circuit board (PCB) 13 using any suitable means, for example in a sealing manner using adhesive so that a gas within the interior chamber is substantially contained from the outside environment.

A component sensor 16 is provided for sensing a variable parameter of the electrical component 12. The component sensor 16 may be positioned proximate or in contact with the heat sink 14 or may receive sensing signals from at least one connected probe 23 positioned proximate or in contact with the heat sink. Alternatively, or additionally, for example, at least one connected probe may be positioned in contact with the electrical component and/or between the heat sink 14 and the electrical component 12. The component sensor 16 provides output in any suitable form indicative of the variable parameter to a charging circuit 18.

The charging circuit 18 is provided for outputting an electrical signal to the heat sink 14 dependent on the input received from the component sensor 16. If the variable parameter is outside of an allowable range, the charging circuit 18 is configured first to charge the heat sink 14 using a connected power supply or battery at a first polarity with the aim of repelling oppositely charged particles. This is possible because the heat sink is not grounded. The feedback from the component sensor 16 may be periodically or continuously monitored or sampled to ascertain the effect of the charging. If the charging does not cause an improvement in the variable parameter (returning it in the direction of the allowable range) or if it does not return within said allowable range after a period of time, the charging circuit 18 may thereafter reverse the applied signal polarity to charge the heat sink 14 accordingly. Thus, if negatively charged particles are adhered to the heat sink 14, then changing from a positive to a negative charging of the heat sink 14 should result in the particles being repelled.

When the variable parameter of the electrical component 12 is within the allowable range, the heat sink 14 may be selectively grounded so as to discharge the current polarity. The charging functionality may also be switched off to save power.

This general feedback process may repeat based on the period or continuous sensing by the component sensor 16 such that particles are repelled efficiently. This also enables the system 10 to adapt to different environments whereby conditions may change. For example, a portable electronic device may experience positively charged dust particles in a first environment but negatively charged dust particles in another environment.

In an example embodiment, the sensed variable parameter is temperature. Thus, the component sensor 16 may be a temperature sensor positioned proximate or in contact with the heat sink 14 or is a device which receives sensing signals from a connected probe positioned proximate or in contact with the heat sink.

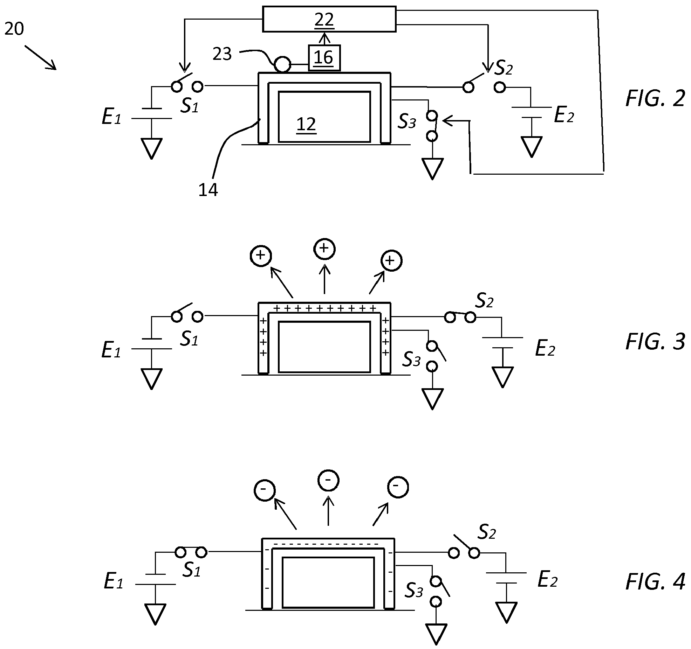

FIGS. 2 - 4 show a first example circuit 20 which may provide the charging circuit 18 in respective states. The first example circuit 20 comprises first and second power supplies or batteries E1, E2. The first power supply E1 is connected to the heat sink 14 through a first switch S1. The second power supply E2 is connected also to the heat sink 14 through a second switch S2. A connection to ground is made through a third switch S3. Each of the switches Si, S2, S3 may be controlled by logic 22 (or any other suitable means) associated with the charging circuit 18 which receives feedback on temperature from the component sensor 16.

In the case of FIG. 2, the heat sink 14 is grounded by closure of the third switch S3. This represents a starting state or a state in which the temperature of the heat sink, indicative that the temperature of the component 12, is within an allowable range. The first and second switches Si, S2 are opened to save power.

FIG. 3 is identical to FIG. 2 save for the third switch S3 being opened such that the heat sink 14 is isolated from ground, and the second switch being closed. Due to the polarity of the second power supply E2, the heat sink 14 becomes positively charged and will therefore repel positively charged particles on or in the vicinity of the heat sink 14.

FIG. 4 is identical to FIG. 2 save for the third switch S3 being opened such that the heat sink 14 is again isolated from ground, and the first switch being closed. Due to the polarity of the first power supply E1, the heat sink 14 becomes negatively charged and will therefore repel negatively charged particles on or in the vicinity of the heat sink 14.

In an example embodiment, if when in the FIG. 2 state it is sensed that the temperature is raised above an allowable limit, the logic 22 may cause the circuit 20 to enter either the FIG. 3 or FIG. 4 configuration, whereby the heat sink 14 is charged positively or negatively for a period of time. If the temperature falls below within the allowable limit due to particles being repelled, then the FIG. 1 configuration may be returned to. If however the temperature does not fall after a period of time, the other one of the FIG. 3 or FIG. 4 configurations may be entered to reverse the polarity. Again, the FIG. 1 configuration may be returned to if the temperature falls within the allowable range.

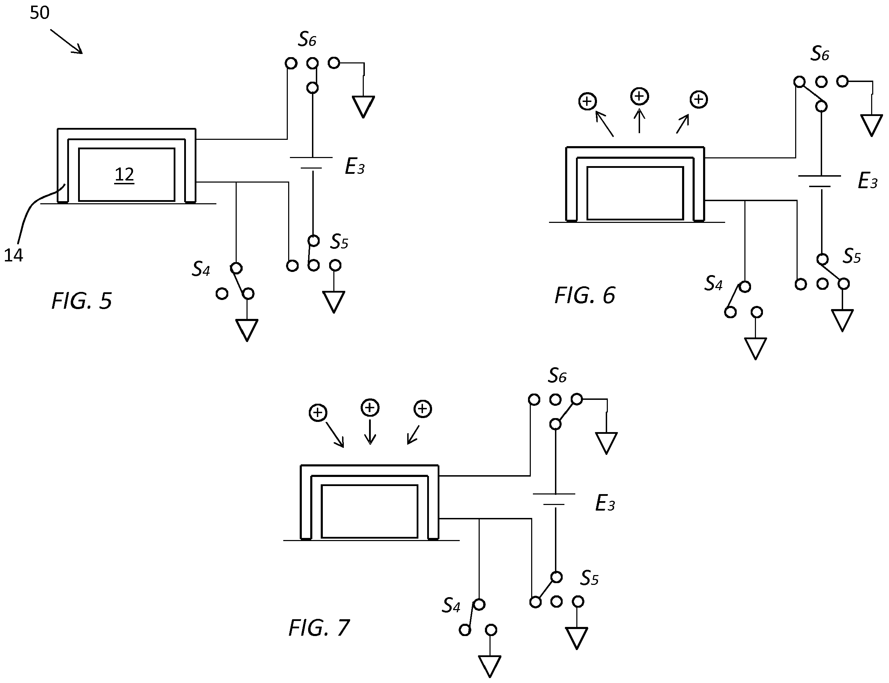

FIGS. 5 - 7 show three configurations of a second example circuit 50 for performing similar functions to the first example circuit 20. The second example circuit 50 differs in that only one power supply or battery E3 is required. A first switch S4 permits the heat sink 14 to be selectively grounded. A second switch D5 is a three-way switch for connecting one terminal of the power supply E3 either to ground, to an open circuit position, or to the heat sink 14. A third switch D6 is a three-way switch for connecting the other terminal of the power supply E3 either to the heat sink 14, to an open circuit position, or to ground. Similar to the first example circuit 20, logic 22 or any other suitable means associated with the charging circuit 18 may be used to set the shown configurations based on the sensed temperature, although such components are not shown for ease of reference.

In the case of FIG. 5, the heat sink 14 is grounded by closure of the first switch S4. This represents a starting state or a state in which the temperature of the heat sink 14, indicative that the temperature of the component 12, is within an allowable range. The second and third switches S5, S6 are in the open-circuit state.

FIG. 6 is identical to FIG. 5 save for the first switch S4 being opened such that the heat sink 14 is isolated from ground, and the third switch S6 being closed. Due to the polarity of the power supply E3, the heat sink 14 becomes positively charged and will therefore repel positively charged particles on or in the vicinity of the heat sink 14.

FIG. 7 is identical to FIG. 5 save for the first switch S4 being opened such that the heat sink 14 is again isolated from ground, and the second switch S5 being closed. Due to the polarity of the power supply E3, the heat sink 14 becomes negatively charged and will therefore repel negatively charged particles on or in the vicinity of the heat sink 14.

In an example embodiment, if when in the FIG. 5 state it is sensed that the temperature is raised above an allowable limit, the charging circuit may cause the circuit 50 to enter either the FIG. 6 or FIG. 7 configuration, whereby the heat sink 14 is charged positively or negatively for a period of time. If the temperature falls below within the allowable limit due to particles being repelled, then the FIG. 5 configuration may be returned to. If however the temperature does not fall after a period of time, the other one of the FIG. 6 or FIG. 7 configurations may be entered to reverse the polarity. Again, the FIG. 5 configuration may be returned to if the temperature falls within the allowable range.

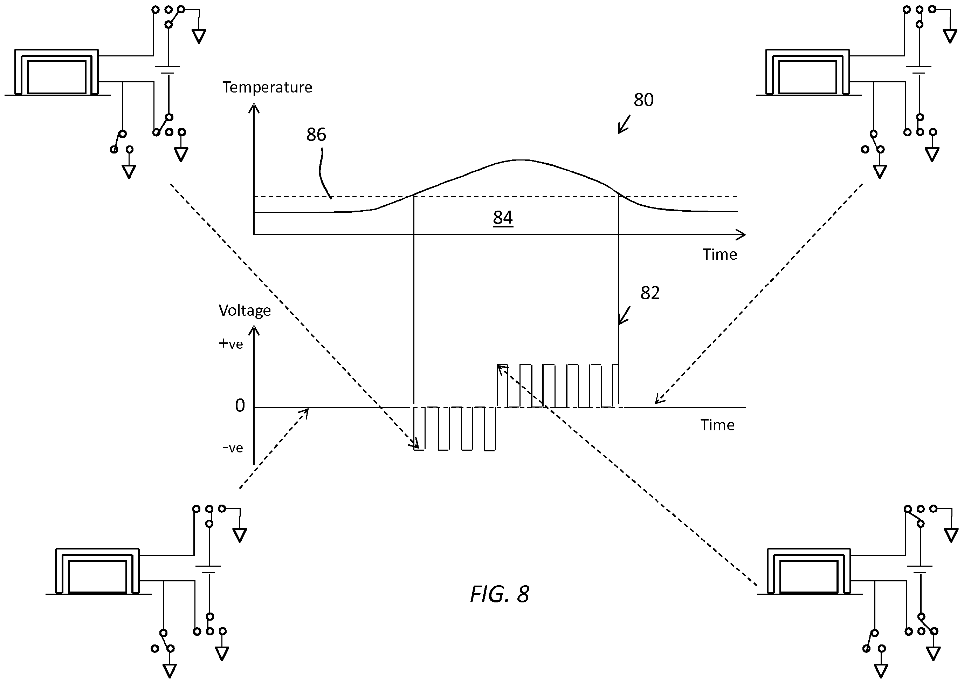

For completeness, FIG. 8 shows first and second graphs 80, 82 respectively showing an example plot of temperature and charge circuit signal against time, and the configurations shown in FIGS. 5 - 7 employed at each stage. It will however be appreciated that equivalent configurations of the first example circuit 20 may be employed.

It will be observed that the signal generated by the charging circuit 18 when the temperature increases outside the allowable range 84, that is above an allowable threshold 86, may be a pulsed, e.g. square-wave signal, or similar intermittent signal. This enables charging of the appropriate polarity and maintenance of that charge whilst conserving battery power, because the heat sink 14 will hold charge when not grounded.

In some embodiments, providing a thermally conductive substance (whether a solid material like aluminium nitride or ceramic, or a gas such as water, ammonia or alcohol) within the space or gap 15 may efficiently transfer heat from the electrical component 12 to the heat sink 14. Any substance or material that electrically isolates the heat sink 14 from the electrical component 12 but conducts thermal energy may be used.

In some embodiments, the temperature sensor may be located in contact, or may form part of, the electrical component 12. For example, the electrical component 12 may have its own built-in temperature sensor that it can communicate to the charging circuit 33. This may be performed using wired or wireless transmission.

In some embodiments, a variable parameter other than temperature may be sensed. For example, some performance characteristic linked to an increase in heat or dust build-up on the electrical component 12 may be monitored for charge control in the same manner. For example, some processor components may be configured automatically to reduce their processing speed in response to a rise in temperature. Example embodiments may therefore involve sensing the processing speed of the electrical component 12 in order to identify a slow-down in speed that may correspond with a rise in temperature due to particulate build-up. In some embodiments, the power consumption of the electrical component 12 may be monitored; generally the efficiency of such a component will go down as temperature increases. If the input power was monitored, any increase may indicate that efficiency is reducing caused by an increase in temperature.

In some embodiments, a plurality of variable parameters may be monitored, and the decision as to whether to charge the heat sink may be based on the collective parameters. For example, taking the above examples of temperature and processing speed, respective allowable ranges may be set and the charging circuit may selectively charge the heat sink 14 only if both parameters go outside their allowable ranges. In this way, a false positive may be avoided if, for example, the processing speed falls for a reason other than an increase in heat due to dust particles.

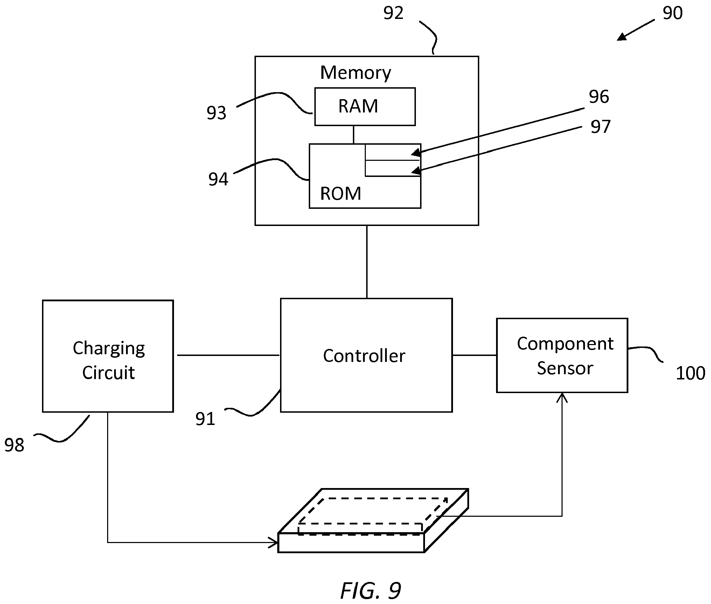

FIG. 9 is a schematic diagram of components of an example control system 90 which may perform the same or similar functions to at least some of the above described the above-described charge circuit 18 examples. It may for example provide a logic control function to any of the shown charge circuit 18 examples.

The control system 90 may have a controller 91, a memory 92 closely coupled to the controller and comprised of at least one random access memory, RAM 93 and at least one read only memory, ROM 94 and an interface 95 that may comprise, or be connected to, at least one sensor 100, e.g. for sensing temperature or processor speed. The control system 90 may be connected to each of the other components to control operation thereof.

The memory 92 may comprise a hard disk drive (HDD) or a solid state drive (SSD). The ROM 94 of the memory 92 may stores, amongst other things, an operating system 96 and/or may store one or more software applications 97. The one or more software applications 97 may provide computer-readable instructions for causing the controller 91 to perform operations to be described below. The RAM 93 is used by the controller 91 for the temporary storage of data. The operating system 96 and/or the software applications 97 may contain code which, when executed by the controller 91 in conjunction with the RAM 93, controls operation of each of the hardware components.

The controller 91 may take any suitable form. For instance, it may be a microcontroller, plural microcontrollers, a processor, plural processors, or processor circuitry.

In some example embodiments, the control system 90 may also be associated with external software applications. These may be applications stored on a remote server device and may run partly or exclusively on the remote server device. These applications may be termed cloud-hosted applications or data. The control system 90 may be in communication with the remote server device in order to utilize the software application stored there.

The controller 91 may communicate with a charging module 98 which may operate according to the configurations shown in FIGS. 2 - 4 and 5 - 7.

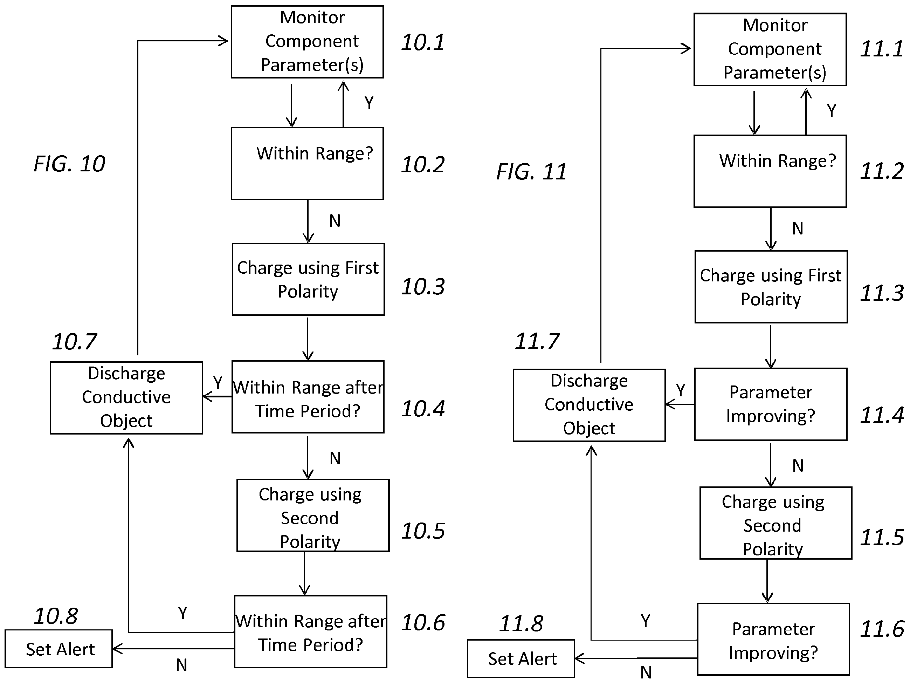

FIG. 10 is a flow diagram showing example operations that may be performed by the control system 90, for example using computer-readable instructions for performing one or more of the following example operations. The computer-readable instructions may be provided as part of a non-transitory computer program product. A first operation 10.1 may comprise monitoring or sensing a component parameter, e.g. temperature or some other variable parameter. A second operation 10.2 may comprise determining if the sensed component parameter is inside or outside of a predetermined range. If inside, the monitoring continues. If outside, a third operation 10.3 may comprise causing the charging module 102 to charge the heat sink 14 using a first polarity. In a fourth operation 10.4, it is determined if the parameter is within range after a time period. If not, in a fifth operation 10.5, the charging polarity is flipped and the charging module 102 charges using a second polarity. If within the range in operation 10.4, the charging module 102 discharges the heat sink 14 by grounding it in operation 10.7. In a sixth operation 10.6, if within the range after a time period, the charging module 102 discharges the heat sink 14 in operation 10.7.

It will be appreciated that some operations may be modified or omitted. Further operations may be added.

In some embodiments, if the sensed parameter does not return to allowable limits, an alert may be issued, e.g. by setting an alert pin to high, prompting manual cleaning of the heat sink 14. This is indicated in operation 10.8.

FIG. 11 is a flow diagram showing example operations according to another example embodiment that may be performed by the control system 90, for example using computer-readable instructions for performing one or more of the following example operations. The computer-readable instructions may be provided as part of a non-transitory computer program product or computer readable medium. A first operation 11.1 may comprise monitoring or sensing a component parameter, e.g. temperature or some other variable parameter. A second operation 11.2 may comprise determining if the sensed component parameter is inside or outside of a predetermined range. If inside, the monitoring continues. If outside, a third operation 11.3 may comprise causing the charging module 102 to charge the heat sink 14 using a first polarity. In a fourth operation 11.4, it is determined if the parameter is improving, e.g. returning towards the allowable range. For example, is the temperature decreasing? If not, in a fifth operation 11.5, the charging polarity is flipped and the charging module 102 charges the heat sink 14 using a second polarity. If there is improvement in operation 11.4, the charging module 102 discharges the heat sink 14 by grounding it in operation 11.7. In a sixth operation 11.6, if the parameter is improving, the charging module 102 will maintain that charge until the parameter no longer improves, and then discharges the heat sink 14 in operation 11.7. If there is no improvement sensed in the sixth operation 11.6, an alert may be issued in operation 11.8, similar to operation 10.8.

In each of the above, it is assumed that the heat sink 14 is not grounded when being charged.

It will be appreciated that some operations may be modified or omitted. Further operations may be added.

In this brief description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some of or all other examples. Thus 'example', 'for example' or 'may' refers to a particular instance in a class of examples. A property of the instance can be a property of only that instance or a property of the class or a property of a sub-class of the class that includes some but not all of the instances in the class. It is therefore implicitly disclosed that a features described with reference to one example but not with reference to another example, can where possible be used in that other example but does not necessarily have to be used in that other example.

Although embodiments of the present invention have been described in the preceding paragraphs with reference to various examples, it should be appreciated that modifications to the examples given can be made without departing from the scope of the invention as claimed.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

Whilst endeavoring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

## Claims

1. Apparatus comprising:
means for sensing a variable property associated with an electrical component;
means for applying an electrical signal to an electrically conductive object in proximity of the electrical component so as to charge said object with either a positive or negative charge in the event that the sensing means senses that the variable property is outside of a predetermined range.

2. The apparatus of claim 1,
further comprising means to selectively apply the electrical signal to the electrically conductive object so as to charge it with the opposite charge polarity in the event that the sensing means senses that the variable property has not returned towards, or is not within, the allowable range.

3. The apparatus of claim 1 or claim 2, further comprising means to connect the electrically conductive object to ground or earth in the event that the sensing means senses that the variable property is in the allowable range.

4. The apparatus of any preceding claim, wherein the means for applying the electrical signal is configured to apply pulsed signals.

5. The apparatus of any preceding claim, wherein the sensed variable property is temperature associated with the electrical component.

6. The apparatus of claim 5, wherein the sensing means is a temperature sensor proximate to, or in contact with, the electrically conductive object.

7. The apparatus of any of claims 1 to 4, wherein the sensed variable property is indicative of performance of the electrical component.

8. The apparatus of any preceding claim, wherein the sensing means is configured to sense a plurality of variable properties associated with the electrical component and wherein the means to apply the electrical signal charges said object only if the plural variable properties are outside respective different allowable ranges.

9. A system comprising:
an electrically conductive heat sink for location proximate to an electrical component;
an apparatus according to any preceding claim for charging of the heat sink.

10. The system of claim 9, wherein the heat sink is dimensioned and arranged to substantially enclose the electrical component.

11. The system of claim 10, wherein a thermally conductive substance is provided in a chamber defined between the electrical component and the heat sink to permit transfer of heat from the electrical component to the heat sink through said substance, wherein the sensed variable property is temperature associated with the electrical component or heat sink.

12. The system of claim 11, wherein the thermally conductive substance is a gas or vapour.

13. The system of claim 12, wherein the thermally conductive substance is aluminium nitride vapour.

14. A method comprising:
sensing a variable property associated with an electrical component;
applying an electrical signal to an electrically conductive object in proximity of the electrical component so as to charge said object with either a positive or negative polarity in the event that the sensing means senses that the variable property is outside of an allowable range.

15. Computer-readable instructions which, when executed by at least one processor, cause the at least one processor to perform the method of claim 14.
